Europäisches Patentamt

European Patent Office

Office européen des brevets

(11) Veröffentlichungsnummer: **0 252 999 B1**

(12) **EUROPÄISCHE PATENTSCHRIFT**

(45) Veröffentlichungstag der Patentschrift: **22.04.92**

(21) Anmeldenummer: **86109362.3**

(22) Anmeldetag: **09.07.86**

(51) Int. Cl.⁵: **H03K 17/693**, H03K 17/687

(54) **Getaktete CMOS-Schaltung mit mindestens einem CMOS-Schalter.**

(43) Veröffentlichungstag der Anmeldung:
**20.01.88 Patentblatt 88/03**

(45) Bekanntmachung des Hinweises auf die
Patenterteilung:
**22.04.92 Patentblatt 92/17**

(84) Benannte Vertragsstaaten:
**DE FR NL**

(56) Entgegenhaltungen:
**EP-A- 0 115 834**
**US-A- 3 986 046**
**US-A- 4 001 606**
**US-A- 4 508 983**

**PATENTS ABSTRACTS OF JAPAN, Band 7,
Nr. 166 (E-188)[1311], 21. Juli 1983; & JP-A-58
71 717**

**PATENTS ABSTRACTS OF JAPAN, Band 7,
Nr. 111 (E-175)[1256], 14. Mai 1983; & JP-A-58
30 231**

**PATENTS ABSTRACTS OF JAPAN, Band 7,
Nr. 133 (E-78)[8221], 8. November 1978; &
JP-A-53 101 260**

**IEEE JOURNAL OF SOLID-STATE CIRCUITS,**

**Band SC-18, Nr. 3, Juni 1983, Seiten 369-376,
IEEE, New York, US; M. ROCCHI et al.: "GaAs
digital dynamic IC's for applications up to 10
GHz"**

**IEEE JOURNAL OF SOLID-STATE CIRCUITS,
Band SC-18, Nr. 3, Juni 1983, Seiten 261-266,
IEEE, New York, US; N.F. GONCALVES:
"NORA: A racefree dynamic CMOS technique for pipelined logic structures"**

**IEEE TRANSACTIONS ON ACOUSTICS, SPE-
ECH AND SIGNAL PROCESSING, Band 32, Nr.
1, Februar 1984, Seiten 28-33, IEEE, New
York, US; P.R. CAPPELLO et al.: "Optimal
choice of intermediate latching to maximize
throughput in VSLI circuits"**

(73) Patentinhaber: **Deutsche ITT Industries GmbH
Hans-Bunte-Strasse 19 Postfach 840
W-7800 Freiburg i.Br.(DE)**

(72) Erfinder: **Theus, Ulrich, Dr. Ing.
Schönbergstrasse 5b
W-7803 Gundelfingen(DE)**
Erfinder: **Orben, Hans-Josef, Dipl.-Ing. (FH)
Bergstrasse 7
W-7803 Heuweiler(DE)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft eine getaktete CMOS-Schaltung mit mindestens einem CMOS-Schalter aus einem n-Kanal-/p-Kanal-Transistor-Paar( = Transistorpaar), dem ein gegenphasiges Steuersignalpaar zugeführt ist, das mittels einer Ansteuerschaltung aus einem Schaltsignal erzeugt ist, vgl. den Oberbegriff des Anspruchs 1.

Der einfachste derartige CMOS-Schalter ist bekanntlich das beispielsweise aus US-A-3 457 435 bekannte CMOS-Transmission-Gate bei dem die gesteuerten Strompfade der beiden Transistoren des Transistorpaares parallelgeschaltet sind und zum Leitend- und Gesperrtsteuern am Gate seines n-Kanal- bzw. p-Kanal-Transistors der n- bzw. p-Takt angelegt wird.

Der Oberbegriff des Anspruchs 1 geht von der US-Patentschrift, US-A-4 001 606, insbesondere Fig.2 aus. Sie zeigt einen einzigen CMOS-Längsschalter für ein Analogsignal, der von einem gegenphasigen Steuersignalpaar in einen elektrisch leitenden oder gesperrten Zustand gesteuert wird. Die Erzeugung des gegenphasigen Steuersignalpaares erfolgt durch eine Ansteuerschaltung, die ein kreuzgekoppeltes n-Kanal-Transistorpaar enthält, deren Drain-Anschlüsse wechselseitig mit den beiden Gate-Anschlüssen des CMOS-Schalters und ferner über p-Kanal-Transistoren mit der positiven Versorgungsspannungsquelle verbunden sind. Die Gate-Anschlüsse dieser p-Kanal-Transistoren sind mit gegenphasigen Schaltsignalen gespeist, die mit Hilfe von Invertern aus einem einphasigen Schaltsignal gebildet sind. Die Source-Anschlüsse des kreuzgekoppelten n-Kanal-Transistorpaares sind zusammengefaßt und auf ein Zwischenpotential geführt, das von dem evtl. negativ werdenden Analogsignal mitgezogen wird.

Aus Patent Abstracts of Japan, Band 7, Nr. 111, (E-175), (1256), 14 Mai 1983 mit Bezug auf JP-A-58-30 231, ist eine getaktete CMOS-Schaltung mit einer Vielzahl von CMOS-Schaltern bekannt. Die Gate-Anschlüsse der CMOS-Schalter sind dabei entweder direkt an die gegenphasigen Ausgänge von getakteten D-Flipflop-Stufen angeschlossen, oder das gegenphasige Ansteuersignal ist auf übliche Weise durch direkte und indirekte Ansteuerung über einen Inverter gebildet. Das einphasige Ansteuersignal ist dabei über ein weiteres Gatter jeweils mit einem Ausgang dreier getakteter D-Flipflop-Stufen gekoppelt.

In der europäischen Patentanmeldung EP-A-115 834, insbesondere Figuren 2c, 3a, 3b, 3f, 3g mit Beschreibung auf den Seiten 4 bis 8 wird auf ein spezielles Problem bei derartigen CMOS-Schaltung hingewiesen. Danach tritt bei der Umschaltung das Problem der clock race auf, also ein Sachverhalt, bei dem es zu einer schnelleren als taktsynchron erfolgenden Nutzsignaldurchschaltung kommt, was auf die Flankenüberlappung der Taktsignale zurückzuführen ist. Die Lösung dieses Problems wird nach der genannten EP-A-115 834 in einer insgesamt getakteten CMOS-Schaltung gesehen, bei der die einzelnen Teilschaltungen, insbesondere von logischen Gattern, im Hinblick auf die race-Freiheit speziell ausgelegt sind.

Die Erfinder haben ferner festgestellt, daß durch die Flankenüberlappung außerdem am Ausgang der Transistorpaare kurze Störimpulse, die als Nutzsignale wirken können, auftreten. Dies ist insbesondere dann von Nachteil, wenn z.B. mehrere solcher Paare zu einem Schaltnetzwerk vereinigt sind, etwa dadurch daß die gesteuerten Strompfade mehrerer n-Kanaltransistoren in Serie geschaltet eine erste Reihenschaltung bilden, die gesteuerten Strompfade einer gleichen Anzahl von p-Kanaltransistoren ebenfalls in Serie geschaltet eine zweite Reihenschaltung bilden und beide Reihenschaltungen parallelgeschaltet sind.

Die Aufgabe der in den Ansprüchen angegebenen Erfindung besteht in der Vermeidung dieser Störimpulse.

Nach der Erfindung wird unterschieden, ob das Transistorpaar vom H-Pegel des Schaltsignals oder von dessen L-Pegel leitend gesteuert werden soll. Auf dieser Unterscheidung fußend besteht der Grundgedanke der Erfindung darin, für die beiden Schaltsignalpegel getrennte Zweige zur Erzeugung und Zuführung der Taktsignale an die CMOS-Schalter vorzusehen, und zwar derart, daß die Flankenüberlappung in beiden Fällen nur im gesperrten Zustand der Transistoren des jeweiligen Transistorpaars auftritt.

Die Erfindung wird nun anhand der Figuren der Zeichnung näher erläutert.

Fig. 1 zeigt das Schaltbild eines Ausführungsbeispiels der Erfindung,

Fig. 2 zeigt das Schaltbild einer Weiterbildung der Erfindung, und

Fig. 3 zeigt das stark schematisierte Schaltbild einer Ausgestaltung der Erfindung für mehrere Schaltsignale und Transistorpaare.

Das Schaltbild des Ausführungsbeispiels nach Fig. zeigt die Ansteuerschaltung c für die beiden gezeigten Transistorpaare tp, die als die erwähnten CMOS-Transmission-Gates gezeichnet sind, wobei das obere Transistorpaar durch den H-Pegel und das untere Transistorpaar durch den L-Pegel des Schaltsignals x leitend gesteuert wird. Die erwähnten Schaltsignalpegel sind an den einzelnen Punkten der Schaltung jeweils mit den entsprechenden Großbuchstaben derart in Klammern angegeben, daß wie beim Schaltsignal x an erster Stelle in der Klammer der dem H-Pegel zugehörige und nach dem Strichpunkt der dem L-Pegel zugehörige Signalwert angegeben ist. Da bekanntlich ein p-Kanal-Transistor durch einen L-Pegel und ein n-Kanal-Transistor durch einen H-Pegel leitend gesteuert wird, wird also der H-Pegel des Schaltsignals x, dem der L-Pegel des inversen Schaltsignals xq zugeordnet ist, die beiden Transistoren des oberen Transistorpaars tp leitend steuern, da dem Gate des p-Kanal-Transistors über den Ausgang a22 der Ansteuerschaltung c ein L-Pegel und dem Gate des n-Kanal-Transistors über den Ausgang a22 ein H-Pegel zugeführt ist; an den beiden Ausgängen a21, a22 wird also das H-Steuersignalpaar hp abgegriffen.

Die umgekehrten Verhältnisse liegen beim unteren Transistorpaar tp vor, das vom L-Pegel des Schaltsignals x leitend gesteuert wird, da dem Gate des p-Kanal-Transistors über den Ausgang a12 der Ansteuerschaltung c ein L-Pegel und dem Gate des n-Kanal-Transistors über den Ausgang a11 ein H-Pegel zugeführt wird; an den beiden Ausgängen a11, a12 wird also das L-Steuersignalpaar lp abgegriffen.

In Fig. ist rechts neben den beiden Transistorpaaren tp der Signalverlauf des jeweiligen Steuersignalpaars hp, lp für die genannten beiden Pegel des Schaltsignals x schematisch gezeigt, und zwar für einen Schaltsignalwechsel von H nach L, wobei das untere Transistorpaar tp durch diesen Wechsel leitend gesteuert werden soll; dieser (neue) Schaltzustand entspricht also den jeweils rechts von der Kreuzung der Flanken liegenden Kurventeilen. Es ist ersichtlich, daß die Flankenüberlappung schon zu einem Zeitpunkt erfolgt, in dem die jeweilige Amplitude der beiden Steuersignale eines Paares noch so groß ist, daß jeder Transistor jedes Transistorpaars tp vollständig gesperrt ist. Würde das obere Transistorpaar tp ebenfalls wie das untere an den Ausgängen a11, a12 angeschlossen sein, so würden, da der Flankenkreuzungspunkt bei einem H/L-Wechsel des Schaltsignals x dann in der Nähe des L-Pegels liegt, beide Transistoren kurzzeitig leitend sein und so einen Störimpuls ermöglichen.

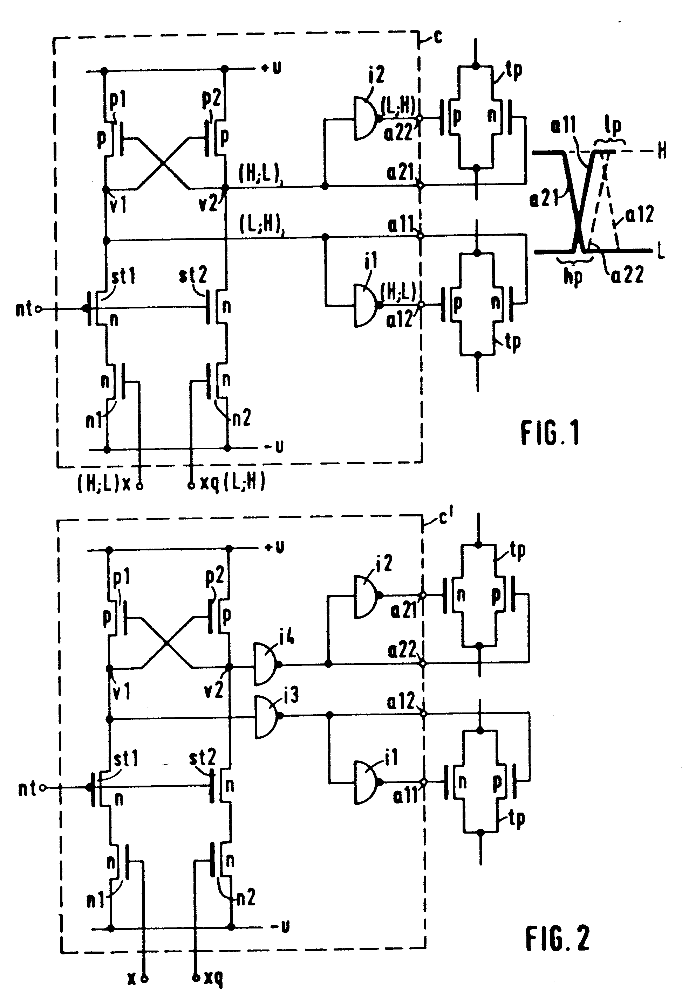

Im Ausführungsbeispiel der Fig. 1 hat die Ansteuerschaltung c den folgenden Aufbau: Zwischen dem positiven Pol +u und dem negativen Pol -u der Betriebsspannungsquelle liegen in dieser Reihenfolge zwei Serienschaltungen aus jeweils einem p-Kanal-Transistor, einem n-Schalttransistor und einem n-Kanal-Transistor. Dies sind in der einen Serienschaltung der erste p-Kanal-Transistor p1, der erste n-Schalttransistor st1 und der erste n-Kanal-Transistor n1 und in der anderen Serienschaltung der zweite p-Kanal-Transistor p2, der zweite n-Schalttransistor st2 und der zweite n-Kanal-Transistor n2. Das Gate des ersten bzw. des zweiten p-Kanal-Transistors p1, p2 liegt am Strompfad-Verbindungspunkt des zweiten p-Kanal-Transistors p2 und des zweiten n-Schalttransistors st2 (im folgenden kurz zweiter Strompfad-Verbindungspunkt v2 genannt) bzw. am entsprechend benannten ersten Strompfad-Verbindungspunkt v1 des ersten p-Kanal-Transistors p1 und des ersten n-Schalttransistors st1. Das jeweilige Gate der n-Schalttransistoren st1, st2 ist mit dem n-Takt nt gespeist. Dies ist das eine der beiden zueinander inversen, in getakteten CMOS-Schaltungen üblichen Taktsignale, vgl. die eingangs genannte EP-A-115 834.

Dem Gate des ersten n-Kanal-Transistors n1 ist das binäre Schaltsignal x und dem des zweiten n-Kanal-Transistors n2 das dazu inverse Schaltsignal xq zugeführt. Dem ersten bzw. zweiten Strompfad-Verbindungspunkt v1, v2 ist der erste bzw. zweite Inverter i1, i2 nachgeschaltet, deren jeweiliger Ausgang zum Ausgang a12 bzw. a22 der Ansteuerschaltung c führt, während der Ausgang a11, a21 am ersten bzw. zweiten Strompfad-Verbindungspunkt v1, v2 direkt angeschlossen ist.

Hat der n-Takt einen H-Pegel, wird durch einen H-Pegel des Schaltsignals x der erste n-Kanal-Transistor n1 leitend gesteuert und durch den inversen L-Pegel des inversen Schaltsignals xq zugleich der zweite n-Kanal-Transistor n2 in den Sperrzustand gesteuert. Ändert das Schaltsignal x seinen Zustand in einen L-Pegel sowie das inverse Schaltsignal xq in einen H-Pegel, so treten gerade die umgekehrten Verhältnisse ein.

Die Fig. 2 zeigt das Schaltbild einer Weiterbildung der Erfindung, und zwar dahingehend, daß die nunmehr vorliegende Ansteuerschaltung c' zwei weitere Inverter aufweist. Sollen nämlich mit der Ansteuerschaltung c nach Fig. 1 mehrere, wenn nicht sogar viele Transistorpaare tp angesteuert werden, so muß die Ansteuerschaltung c dazu in der Lage sein, deren viele Gate-Kapazitäten auch ausreichend schnell aufzuladen. Dazu ist es bekanntlich erforderlich, die Ausgangsstufen von dafür erforderlichen Treiberschaltungen im Layout der integrierten Schaltung entsprechend großflächig auszubilden. Bei Fig. 2 wird dies dadurch erreicht, daß dem ersten bzw. zweiten Inverter i1, i2 der dritte bzw. vierte Inverter i3, i4 vorgeschaltet ist, von dessen jeweiligem Ausgang das Transistorpaar tp und der erste bzw. der zweite Inverter i1, i2 anstatt vom ersten bzw. zweiten Strompfad-Verbindungspunkt v1, v2 angesteuert ist. Die vier Inverter sind dann entsprechend der anzusteuernden Lastkapazität flächenmäßig dimensioniert. Die übrigen Bestandteile der Ansteuerschaltung c' nach Fig. 2 sind identisch mit denen der Ansteuerschaltung c nach Fig. 1.

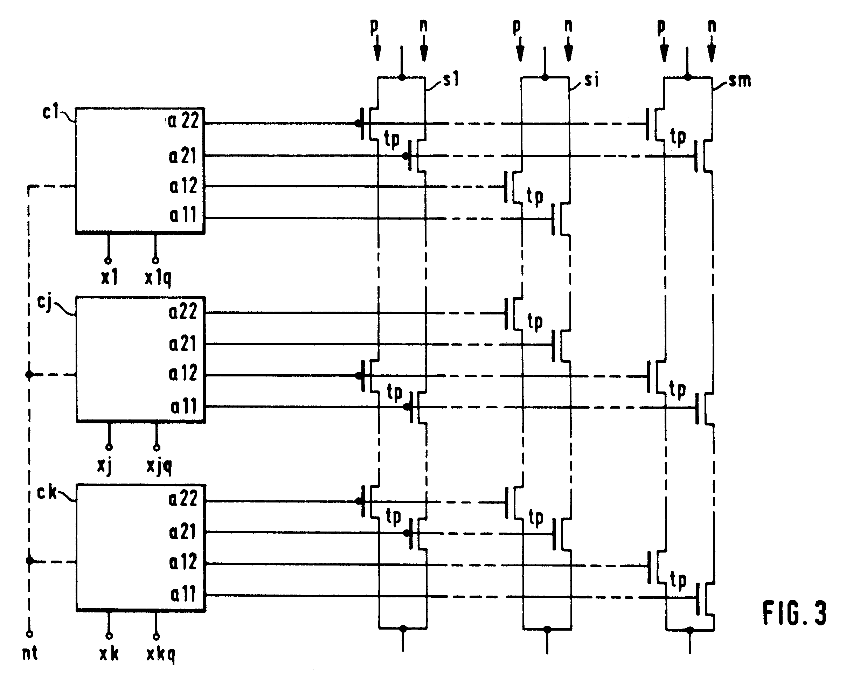

Die Fig. 3 zeigt schließlich das stark schematisierte Schaltbild einer Anordnung, die mittels k binärer Schaltsignale x1... xj... xk maximal $2^k = m$ elektronische Schalter s1... si... sm leitend steuert. Dabei ist jeweils eines der k binären Schaltsignale einer von k Ansteuerschaltungen c1... cj...ck zugeführt, die entsprechend einer der Anordnungen

3

nach den Fig. 1 bis 3 ausgebildet sein können; darauf weist auch die gestrichelt gezeichnete Eingangsleitung für den n-Takt nt hin.

Von den maximal möglichen m elektronischen Schaltern sind die Schalter s1, si und sm in Fig. 3 gezeigt. Sie bestehen jeweils, wie oben schon kurz erwähnt wurde, aus der ersten Serienschaltung der gesteuerten Strompfade von k p-Kanal-Transistoren und der zweiten Serienschaltung der gesteuerten Strompfade von k n-Kanal-Transistoren, welche beiden Serienschaltungen parallelgeschaltet sind und zwischen dem Ein- und Ausgang des elektronischen Schalters angeordnet sind. Jeweils ein n- und ein p-Kanal-Transistor vom gleichen Index bilden ein Transistorpaar tp. In Abhängigkeit davon, mit welchem Binärpegel des zugeordneten Schaltsignals x1...xj...xk, x1q... xjq...xkq die Transistoren des jeweiligen Transistorpaars leitend gesteuert werden sollen, sind die Gates der p-Kanal-Transistoren mit den Ausgägen a12 oder a22 und die Gates der n-Kanal-Transistoren mit den Ausgängen a11 oder a21 der jeweiligen Ansteuerschaltung verbunden.

So liegen im elektronischen Schalter s1 die Gates des ersten und des letzten p-Kanal-Transistors am jeweiligen Ausgang a22 der ersten bzw. letzten Ansteuerschaltung c1, ck, während des Gate des j-ten p-Kanal-Transistors am Ausgang 12 der Ansteuerschaltung cj angeschlossen ist. Demzufolge liegt das Gate des jeweils zugeordneten n-Kanal-Transistors am Ausgang a21 bzw a11 der Ansteuerschaltungen c1, ck bzw. cj.

Im elektronischen Schalter si ist das Gate des ersten p-Kanal-Transistors mit dem Ausgang a12 der Ansteuerschaltung c1 verbunden, während das Gate des j-ten und das des letzten p-Kanal-Transistors mit dem jeweiligen Ausgang a22 der Ansteuerschaltung cj, ck verbunden ist. Entsprechend liegt das Gate des ersten n-Kanal-Transistors am Ausgang a11 der Ansteuerschaltung c1 und das jeweilige Gate des j-ten bzw. letzten n-Kanal-Transistors am jeweiligen Ausgang a21 der Ansteuerschaltung cj bzw. ck.

Beim letzten elektronischen Schalter sm ist das erste Transistorpaar den Ausgängen a21, a22 der Ansteuerschaltung c1, dagegen das j-te und das letzte Transistorpaar den Ausgängen a11, a12 der Ansteuerschaltungen cj bzw. ck zugeordnet.

Die Anordnung nach Fig. 3 kann z.B. als Datenselektor dienen, mit dem aus m Stellen eines Datensignals in Abhängigkeit der k Stellen des Schaltsignals eine entsprechende Auswahl getroffen werden kann.

Da bei der Erfindung die Ansteuersignale für das jeweilige Gate der Transistoren des Transistorpaars für jeden der beiden Signalpegel des Schaltsignals getrennt so erzeugt werden, daß die Überlappung nur im inaktiven Bereich der Transistoren auftritt, treten auch bei umfangreichen Anordnungen mit einer Vielzahl von Transistorpaaren, vgl. z.B. die Fig. 3, keine Störimpulse auf, wie dies der Fall wäre, wenn für beide Pegel des Schaltsignals dieselben Ansteuersignale der Transistorpaare vorgesehen würden.

Die CMOS-Schaltung nach der Erfindung wird selbstverständlich im Rahmen integrierter Schaltungen realisiert, wie dies für CMOS-Schaltungen generell üblich ist.

## Patentansprüche

1. Getaktete CMOS-Schaltung mit mindestens einem CMOS-Schalter aus einem n-Kanal-/p-Kanal-Transistor-Paar (tp), dem ein gegenphasiges Steuersignalpaar zugeführt ist, das mittels einer Ansteuerschaltung (c) aus einem Schaltsignal (x) erzeugt ist, wobei:

   - die Ansteuerschaltung (c) ein kreuzgekoppeltes MOS-Transistorpaar (p1, p2) des einen Leitungstyps enthält, dessen jeweiliger Drain-Anschluß über einen MOS-Kanal-Transistor des anderen Leitungstyps (n1, n2) mit einem Pol der Betriebsspannungsquelle verbunden ist,

   - die MOS-Kanal-Transistoren (n1, n2) des anderen Leitungstyps sind gegenphasig mit dem Schaltsignal (x) und einem dazu inversen Schaltsignal (xq) gespeist, und

   - an den Drain-Anschlüssen des kreuzgekoppelten Transistorpaares (p1, p2) ist das gegenphasige Steuersignalpaar abgegriffen,

   gekennzeichnet durch folgende Merkmale:

   - zwischen die Drain-Anschlüsse des kreuzgekoppelten MOS-Transistorpaares des einen Leitungstyps (p1, p2) und die zugehörigen Drain-Anschlüsse der MOS-Kanal-Transistoren des anderen Leitungstyps (n1, n2) ist jeweils ein MOS-Schalttransistor (st1, st2) vom gleichen Leitungstyp wie die MOS-Kanal-Transistoren (n1, n2) eingefügt,

   - die Gate-Anschlüsse der MOS-Schalttransistoren (st1, st2) sind gemeinsam von einem Takt (nt) gesteuert, und

   - als Steuersignalpaare erzeugt die Ansteuerschaltung (c) ein H- und L-Steuersignalpaar (hp, lp), wobei der CMOS-Schalter beim H- bzw. L-Steuersignalpaar vom H- bzw. L-Pegel des Schaltsignals (x) leitend gesteuert ist,

   - sodaß beim Umschalten nicht beide Transistoren des CMOS-Schalters gleichzeitig leitend sind.

**2.** CMOS-Schaltung nach Anspruch 1 mit einer wie folgt aufgebauten Ansteuerschaltung (c):

- zwischen dem positiven (+u) und dem negativen Pol (-u) einer Betriebsspannungsquelle liegen in dieser Reihenfolge jeweils die in Serie geschalteten gesteuerten Strompfade eines ersten p-Kanal-Transistors (p1), eines ersten n-Schalttransistors (st1) und eines ersten n-Kanal-Transistors (n1) bzw. eines zweiten p-Kanal-Transistors (p2), eines zweiten n-Schalttransistors (st2) und eines zweiten n-Kanal-Transistors (n),

- das Gate des ersten p-Kanal-Transistors (p1) liegt am Strompfad-Verbindungspunkt des zweiten p-Kanal-Transistors (p2) und des zweiten n-Schalttransistors (st2) (= zweiter Strompfadverbindungspunkt) (v2) und das Gate des zweiten p-Kanal-Transistors (p2) am Strompfad-Verbindungspunkt des ersten p-Kanal-Transistors (p1) und des ersten n-Schalttransistors (st1) (= erster Strompfad-Verbindungspunkt) (v1),

- dem Gate des ersten n-Kanal-Transistors (n1) ist das Schaltsignal (x) und dem des zweiten n-Kanal-Transistors (n2) das dazu inverse Schaltsignal (xq) zugeführt,

- den Gates der n-Schalttransistoren ist der n-Takt (nt) zugeführt,

- dem ersten bzw. zweiten Strompfad-Verbindungspunkt (v1, v2) ist ein erster bzw. zweiter Inverter (i1, i2) nachgeschaltet, und

- wenn das Transistor-Paar (tp) vom L-bzw. H-Pegel des Schaltsignals (x) leitend zu steuern ist, liegt das Gate von dessen n-Kanal-Transistor am ersten bzw. am zweiten Strompfadverbindungspunkt (v1, v2) und das Gate von dessen p-Kanal-Transistor am Ausgang des ersten bzw. zweiten Inverters (i1, i2).

**3.** CMOS-Schaltung nach Anspruch 2 mit entsprechend der anzusteuernden Lastkapazität flächenmäßig dimensioniertem, dem ersten bzw. dem zweiten Inverter (i1, i2) vorgeschaltetem dritten bzw. vierten Inverter (i3, i4), von dessen jeweiligem Ausgang das Transistorpaar (tp) und der erste bzw. zweite Inverter (i1, i2) anstatt vom ersten bzw. zweiten Strompfad-Verbindungspunkt (v1, v2) angesteuert ist.

**4.** CMOS-Schaltung nach Anspruch 2 oder 3, die mittels k binärer Schaltsignale (x1... xj... xk), von denen jeweils eines jeweils einer von k Ansteuerschaltungen (c1... cj... ck) zugeführt ist, maximal $2_k$ = m elektronische Schalter (s1... si... sm) leitend steuert, von denen jeder aus einer ersten bzw. zweiten Serienschaltung der gesteuerten Strompfade von k p-Kanal-Transistoren bzw. k n-Kanal-Transistoren besteht, welche beiden Serienschaltungen parallel zwischen dem Eingang und dem Ausgang des elektronischen Schalters liegen.

**Claims**

**1.** Clocked CMOS circuit comprising at least one CMOS switch consisting of an n-channel-/p-channel-transistor pair (tp) which is supplied with a drive-signal pair of opposite phase derived from a switching signal (x) by means of a drive circuit (c), with

- the drive circuit (c) including a cross-coupled MOS-transistor pair (p1, p2) of one conductivity type whose drain terminals are connected through respectively associated MOS-channel transistors (n1, n2) of the other conductivity type to one terminal of the supply-voltage source,

- the MOS-channel transistors (n1, n2) of said other conductivity type are fed in phase opposition with the switching signal (x) and a switching signal (xq) inverted with respect thereto, and

- the drive-signal pair of opposite phase being taken from the drain terminals of the cross-coupled transistor pair (p1, p2), characterized by the following features:

- An MOS switching transistor (st1, st2) of the same conductivity type as that of the MOS-channel transistors (n1, n2) is inserted between each of the drain terminals of the cross-coupled MOS transistor pair (p1, p2) of said one conductivity type and the associated drain terminal of the MOS-channel transistors (n1, n2) of said other conductivity type;

- the gate terminals of the MOS switching transistors (st1, st2) are controlled by a common clock signal (nt), and

- as drive-signal pairs, the drive circuit (c) generates an H drive-signal pair (hp) and an L drive-signal pair (lp), with the CMOS switch rendered conducting by the H level of the switching signal (x) in the presence of the H drive-signal pair and by the L level of the switching signal (x) in the presence of the L drive-signal pair,

- so that upon switchover, the two transistors of the CMOS switch are not simultaneously on.

**2.** A CMOS circuit as claimed in claim 1 with a drive circuit (c) constructed as follows:

- A series combination of the controlled current paths of a first p-channel transistor (p1), a first n-switching transistor (st1), and a first n-channel transistor (n1) and a series combination of a second p-channel transistor (p2), a second n-switching transistor (st2), and a second n-channel transistor (n) are connected between the positive terminal ( + u) and the negative terminal (-u) of a supply-voltage source;
- the gate of the first p-channel transistor (p1) is connected to the current-path junction of the second p-channel transistor (p2) and the second n-switching transistor (st2) (= second current-path junction v2), and the gate of the second p-channel transistor (p2) is connected to the current-path junction of the first p-channel transistor (p1) and the first n-switching transistor (st1) (= first current-path junction v1);
- the gate of the first n-channel transistor (n1) is fed with the switching signal (x), and that of the second n-channel transistor (n2) with the switching signal inverted with respect thereto (xq);
- the gates of the n-switching transistors are fed with the n-clock (nt);
- the first and second current-path junctions (v1, v2) are followed by a first inverter (i1) and a second inverter (i2), respectively, and
- if the transistor pair (tp) is to be rendered conducting by the L or H level of the switching signal (x), the gate of the n-channel transistor of the transistor pair (tp) is connected to the first current-path junction (v1) or the second current-path junction (v2), respectively, and the gate of the p-channel transistor to the output of the first inverter (i1) or the second inverter (i2), respectively.

3. A CMOS circuit as claimed in claim 2, comprising a third inverter (i3) and a fourth inverter (i4) ahead of the first inverter (i1) and the second inverter (i2), respectively, the output of the third inverter (i3) driving the associated transistor pair (tp) and the first inverter (i1) instead of the first current-path junction (v1), and the output of the fourth inverter (i4) driving the associated transistor pair (tp) and the second inverter (i2) instead of the second current-path junction (v2), and the areas of the third and fourth inverters (i3, i4) being dimensioned in accordance with the load capacitance to be driven.

4. A CMOS circuit as claimed in claim 2 or 3 which renders a maximum of $2^k = m$ electronic switches (s1...si...sm) conducting by means of k binary switching signals (x1...xj...xk) each applied to one of k drive circuits (c1...cj...ck),each of the electronic switches consisting of two series combinations of the controlled current paths of k p-channel transistors and k n-channel transistors, the two series combinations being connected in parallel between the input and the output of the electronic switch.

**Revendications**

1. Circuit CMOS commandé de façon cadencée, comportant au moins un interrupteur CMOS constitué par un couple (tp) de transistors à canal n / à canal p, auquel est envoyé un couple de signaux de commande en opposition de phase, qui est produit au moyen d'un circuit de commande (c) à partir d'un signal de commutation (x), et dans lequel
   - le circuit de commande (c) contient un couple (p1, p2) de transistors MOS couplés selon un couplage croisé, possédant un premier type de conduction et dont une borne respective de drain est raccordée par l'intermédiaire d'un transistor à canal MOS possédant l'autre type de conduction (n1, n2) à un pôle de la source de tension de service,
   - les transistors à canal MOS (n1,n2) possédant l'autre type de conduction sont alimentés, en opposition de phase, par le signal de commutation (x) et par un signal de commutation (xq) inverse du précédent, et
   - le couple de signaux de commande en opposition de phase est prélevé sur les bornes de drain du couple de transistors (p1,p2) couplés selon un couplage croisé,
   caractérisé par les caractéristiques suivantes :
   - entre les bornes de drain du couple de transistors MOS (p1,p2) couplés selon un couplage croisé et possédant un premier type de conduction et les bornes de drain associées des couples de transistors à canal MOS (n1,n2) possédant l'autre type de conduction est inséré respectivement un transistor de commutation MOS (st1, st2) possédant le même type de conduction que les transistors à canal MOS (n1, n2),
   - les bornes de grille des transistors de commutation MOS (st1, st2) sont commandées en commun par une cadence (nt), et

- le circuit de commande (c) produit, comme couples de signaux de commande, un couple (hp,lp) de signaux de commande H et L, l'interrupteur CMOS étant placé à l'état conducteur par le niveau H ou L du signal de commutation (x), dans le cas du couple de signaux de commande H ou L,

- de sorte que, lors de la commutation, les deux transistors de l'interrupteur CMOS ne sont pas tous deux simultanément conducteurs.

2. Circuit CMOS selon la revendication 1, comportant un circuit de commande (c) agencé de la manière suivante :

- entre le pôle positif ( + u) et le pôle négatif (-u) d'une source de tension de service sont disposés, et ce dans cet ordre, respectivement les voies de courant commandées, branchées en série, d'un premier transistor (p1) à canal p, d'un premier transistor de commutation n (st1) et d'un premier transistor (n1) à canal n ou d'un second transistor (p2) à canal p, d'un second transistor de commutation n (st2) et d'un second transistor (n) à canal n,

- la grille du premier transistor (p1) à canal p est raccordée au point de jonction des voies de courant du second transistor (p2) à canal p et du second transistor de commutation n (st2) ( = second point de jonction des voies de courant) (v2) et la grille du second transistor (p2) à canal p est raccordée au point de jonction des voies de courant du premier transistor (p1) à canal p et du premier transistor de commutation n (st1) ( = premier point de jonction des voies de courant) (v1),

- le signal de commutation (x) est envoyé à la grille du premier transistor (n) à canal n et le signal de commutation (xq), inverse du précédent, est envoyé à la grille du second transistor (n2) à canal n,

- la cadence n (nt) est envoyée aux grilles des transistors de commutation n,

- un premier ou un second inverseur (i1, i2) est branché en aval du premier ou du second point de jonction (v1, v2) des voies de courant, et

- lorsque le couple (tp) de transistors doit être placé à l'état conducteur par le niveau L ou H du signal de commutation (x), la grille du transistor à canal n de ce couple est raccordée au premier ou au second point de jonction (v1, v2) des voies de courant et la grille du transistor à canal p de ce couple est raccordée à la sortie du premier ou du second inverseur (i1, i2).

3. Circuit CMOS selon la revendication 2, comportant des troisième et quatrième inverseurs (i3, i4), dont la surface est dimensionnée d'une manière qui correspond à la capacité de charge devant être commandée et qui sont branchés en amont des premier et second inverseurs (i1, i2) dont les sorties respectives commandent le couple (tp) de transistors, et les premier et second inverseurs (i1, i2) sont commandés, au lieu de cela, par les premier et second points de jonction (v1, v2) des voies de courant.

4. Circuit CMOS selon la revendication 2 ou 3, qui, au moyen de k signaux binaires de commutation (x1...xj...xk), dont l'un respectivement est envoyé à l'un respectif de k circuits de commande (c1... cj... ck), place à l'état conducteur au maximum $2^k = m$ interrupteurs électroniques (s1... si... sm), dont chacun est constitué par des premier et second circuits série des voies de courant commandées, de k transistors à canal p et de k transistors à canal n, les deux circuits série étant branchés en parallèle entre l'entrée et la sortie de l'interrupteur électronique.

FIG.1

FIG.2

FIG. 3